# EUROPEAN PATENT APPLICATION

(11) **EP 2 357 629 A1**
(43) Date of publication of application: **17.08.2011**
(21) Application number: 09827519.1
(22) Date of filing: 13.11.2009
(51) Int. Cl.: G09F 9/30, G02F 1/1345, H01L 21/768, H01L 23/522

(54) **SUBSTRATE FOR DISPLAY PANEL, AND DISPLAY PANEL**

(30) Priority: 21.11.2008 JP 2008298208
(71) Applicant: Sharp Kabushiki Kaisha, Osaka-shi, Osaka 545-8522 (JP)
(72) Inventor: UMEZAWA, Takahiro, Osaka-shi, Osaka 545-8522 (JP)
(74) Representative: Hoffmann, Jörg Peter
(86) International application number: PCT/JP2009/069351
(87) International publication number: WO 2010/058738

(57) **Abstract**

A display panel substrate in which a short circuit between electrode terminals is prevented, and a display panel. The display panel substrate includes an electrode terminal (121) for connecting an external circuit board, a drawing line (122) electrically continuous to the electrode terminal (121), an interlayer insulating film (209) covering the drawing line (122), a conductive material film (210) superimposed on the electrode terminal (121) and electrically continuous to the electrode terminal (211), and a conductive material film (211) superimposed on the drawing line 122 while interposing the interlayer insulating film (209) and electrically continuous to the drawing line (122). The conductive material film (210) superimposed on the electrode terminal (121) and the conductive material film (211) superimposed on the drawing line 122 while interposing the interlayer insulating film (209) are separate in a peripheral portion of the interlayer insulating film (209).

## Description

### Technical Field

The present invention relates to a display panel substrate and a display panel, and more specifically relates to a display panel substrate that includes in its peripheral portion terminals (e.g., lands having a strip shape) for electrically connecting a TCP (Tape Carrier Package) and other components, and a substrate that includes the display panel substrate.

### Background Art

A generally used liquid crystal display panel includes two substrates. For example, an active matrix liquid crystal display panel includes a TFT array substrate and a common substrate (for example, a color filter may be used as the common substrate). The substrates are bonded opposed to each other leaving a minute gap therebetween, and liquid crystals are filled between the substrates.

On the TFT array substrate, a display region (active area) and a panel frame region that surrounds the display region are provided. In the display region, a plurality of pixel electrodes are arranged in a matrix, and switching elements (e.g., thin film transistors (TFTs)) arranged to drive the pixel electrodes are arranged. In the display region, scanning lines and data lines (source bus lines) that are arranged to transfer given signals to the switching elements are provided. In the panel frame region, electrode terminals (e.g., lands) for connecting a TCP (Tape Carrier Package) on which driver ICs (source drivers or gate drivers) are provided are provided. In the panel frame region, lines arranged to connect the electrode terminals to the scanning lines and the data lines in the display region are provided.

This configuration allows the signals generated by the driver ICs on the TCP to be transferred through the electrode terminals and the lines in the panel frame region to the scanning lines and the data lines in the display region. Through the scanning lines and the data lines, the signals are distributed to the switching elements.

Some examples of the electrode terminals and the lines in the panel frame region have the following structure. A plurality of electrode terminals and lines that are made from the same material are provided in the same layer on the display panel substrate (a layer directly above a transparent substrate preferably made from glass). The electrode terminals preferably have a thin strip shape. The electrode terminals are provided at given intervals and parallel to one another in a peripheral portion of the panel frame region. In the panel frame region, an interlayer insulating film is provided except for the region where the electrode terminals are provided. Thus, the lines are covered with the interlayer insulating film, and the electrode terminals are not covered with the interlayer insulating film and are exposed.

On the electrode terminals, a film made from a conductive material (e.g., a film made from indium tin oxide) is provided. The conductive material film is superimposed on the lines while interposing the interlayer insulating film. Contact holes are provided in given positions of the interlayer insulating film, which makes the lines and the conductive material film electrically continuous to one another through the contact holes. This configuration provides a multilayer structure of the electrode terminals and the lines, which decreases electrical resistance of the electrode terminals and the lines. As a result, loss of transferred signals can be reduced.

For a method for forming the conductor material film described above, photolithography is preferably used. A brief description of the forming method will be provided. First, a conductive material film is formed on almost all over a display panel substrate on which patterns of electrode terminals and lines and an interlayer insulating film have been formed. Then, a photoresist material film is formed so as to cover the formed conductive material film. Then, the photoresist material film is irradiated with light energy through a photomask having given light shielding patterns and given light transmitting patterns. If the photoresist material is positive, portions of the photoresist material film that are formed on the electrode terminals and the lines are shielded against light energy, and portions of the photoresist material film that are formed between the electrode terminals and between the lines are irradiated with light energy.

Then, given portions of the exposed photoresist material film are removed by development. If the photoresist material film is positive, portions irradiated with light energy are removed, and portions shielded against light energy remain. Thus, the photoresist material film on the electrode terminals and on the lines remains, and the photoresist material film between the electrode terminals and between the lines is removed. As a result, portions of the conductive material film between the electrode terminals and between the lines are exposed.

Then, patterning of the conductive material film by etching is performed by using the photoresist material film of the given pattern as a mask. By the patterning, the exposed conductive material film is removed. To be specific, portions of the conductive material film superimposed on the lines while interposing the electrode terminals and the interlayer insulating film remain, and portions of the conductive material film between the electrode terminals and between the lines are removed. As a result, a multilayer structure of the electrode terminals and the lines is provided.

Recently, there is a need for reducing the number of driver ICs for cost reduction. In order to reduce the number of driver ICs, it is necessary to use driver ICs each having large numbers of output terminals. If the number of output terminals of the driver ICs on the TCP is increased, the number of terminals to be connected between the TCP and the display panel substrate is increased. Therefore, the interval between the electrode terminals and the interval between the lines on the display panel substrate should be decreased. The decreased interval between the electrode terminals or the decreased interval between the lines could cause a short circuit between the electrode terminals or between the lines. Especially, the possibility of causing a short circuit through the conductive material film superimposed on the electrode terminals and the lines is great.

The reason is described. The conductive material film is formed by photolithography as described above. To be specific, the conductive material film is formed first, and the photoresist material film is formed thereon. Then, the photoresist material film is subjected to patterning, and the conductive material film is subjected to patterning by using the photoresist material film having been subjected to the patterning as a mask.

The photoresist material film is also formed on uneven surfaces in a peripheral portion of the interlayer insulating film. The thickness of the photoresist material film on the uneven surfaces in the peripheral portion of the interlayer insulating film depends on the thickness of the interlayer insulating film. In other words, the thickness of the photoresist material film is almost the same as the height of the uneven surfaces in the peripheral portion of the interlayer insulating film. Therefore, the thickness of the photoresist material film on the uneven surfaces in the peripheral portion of the interlayer insulating film is greater than the thickness of the other portions. The greater thickness of the photoresist material film could result in insufficient exposure in an exposure step.

If the photoresist material is positive, insufficiently exposed portions could not be completely removed by development. Because the remaining photoresist material film is used as a mask in the patterning of the conductive material film, if the photoresist material film remains, the conductive material film covered with the remaining photoresist material film remains. As a result, the conductive material film remains between the electrode terminals or between the lines in the peripheral portion of the interlayer insulating film, and the remaining conductive material film causes a short circuit between the electrode terminals or between the lines.

In order to prevent a short circuit between the electrode terminals or between the lines due to the conductive material film, Patent Literatures 1 and 2 make suggestions. Patent Literature 1 discloses that a short circuit between terminals is prevented by providing a wall of an interlayer insulating film between the terminals. Patent Literature 2 discloses that a short circuit between terminals is prevented by smoothing an interlayer insulating film in order to control etching condition of a conductive material film to be formed on the interlayer insulating film. These configurations can prevent a short circuit between the terminals by preventing the conductive material film from being formed between the terminals. However, Patent Literatures 1 and 2 are silent about preventing the photoresist material film from remaining in the peripheral portion of the interlayer insulating film.

### Citation List

### Patent Literature

Patent Literature 1: JP 2000-180890 A
Patent Literature 2: JP 2000-155335 A

### Summary of Invention

### Solution to Problem

An object of the present invention is to overcome the problems described above and to provide a display panel substrate in which a short circuit between electrode terminals is prevented, and a display panel. Another object of the present invention is to provide a display panel substrate in which a short circuit between electrode terminals due to a conductive material film superimposed on the electrode terminals and lines is prevented, and a display panel. Yet another object of the present invention is to provide a display panel substrate in which a short circuit between electrode terminals due to a photoresist material film remaining in a peripheral portion of an interlayer insulating film is prevented, and a display panel.

### Solution to Problem

Preferred embodiments of the present invention provide a display panel substrate including an electrode terminal for connecting an external circuit board, a drawing line electrically continuous to the electrode terminal, an interlayer insulating film covering the drawing line, a conductive material film superimposed on the electrode terminal and electrically continuous to the electrode terminal, and a conductive material film superimposed on the drawing line while interposing the interlayer insulating film and electrically continuous to the drawing line, wherein the conductive material film superimposed on the electrode terminal and the conductive material film superimposed on the drawing line while interposing the interlayer insulating film are separate in a peripheral portion of the interlayer insulating film.

It is preferable that the conductive material film superimposed on the drawing line while interposing the interlayer insulating film and electrically continuous to the drawing line is electrically continuous to the drawing line through an opening provided to the interlayer insulating film.

It is preferable that a portion of the conductive material film superimposed on the drawing line while interposing the interlayer insulating film that is close to the peripheral portion of the interlayer insulating film has a width smaller than a width of the other portion.

Preferred embodiments of the present invention provide a display panel substrate including a plurality of electrode terminals for connecting an external circuit board, a plurality of drawing lines each electrically continuous to the plurality of electrode terminals, an interlayer insulating film covering the plurality of drawing lines, conductive material films each superimposed on the plurality of electrode terminals and electrically continuous to the plurality of electrode terminals, and conductive material films each superimposed on the plurality of drawing lines while interposing the interlayer insulating film and electrically continuous to the plurality of drawing lines, wherein the plurality of drawing lines are parallel to one another, and the conductive material films superimposed on the plurality of electrode terminals and the conductive material films superimposed on the plurality of drawing lines while interposing the interlayer insulating film are separate in a peripheral portion of the interlayer insulating film, and the conductive material films superimposed on the adjacent plurality of drawing lines are separate.

It is preferable that the conductive material films superimposed on the drawing lines while interposing the interlayer insulating film and electrically continuous to the drawing lines are electrically continuous to the drawing lines through openings provided to the interlayer insulating film.

It is preferable that portions of the conductive material films superimposed on the drawing lines while interposing the interlayer insulating film that are close to the peripheral portion of the interlayer insulating film have a width smaller than a width of the other portions.

It is preferable that portions of the conductive material films superimposed on the drawing lines while interposing the interlayer insulating film that are close to the peripheral portion of the interlayer insulating film have a width smaller than a width of the other portions, and an interval between the portions having the smaller width of the conductive material films superimposed on the adjacent drawing lines while interposing the interlayer insulating film is greater than an interval between the other portions of the conductive material films superimposed on the adjacent drawing lines while interposing the interlayer insulating film.

It is preferable that a thickness of portions in the peripheral portion of the interlayer insulating film between the plurality of drawing lines is smaller than a thickness of portions of the interlayer insulating film superimposed on the plurality of drawing lines.

Preferred embodiments of the present invention provide a display panel including the display panel described above and a common substrate, wherein the display panel substrate and the common substrate are opposed to each other leaving a given gap therebetween, and liquid crystals are filled between the display panel substrate and the common substrate.

### Advantageous Effects of Invention

According to the present invention, the conductive material films superimposed on the electrode terminals and the conductive material films superimposed on the drawing lines while interposing the interlayer insulating film are separate in the peripheral portion of the interlayer insulating film. In other words, the conductive material films are not formed in the peripheral portion of the interlayer insulating film. Thus, a short circuit between the adjacent electrode terminals due to the conductive material films superimposed on the electrode terminals, or a short circuit between the adjacent drawing lines due to the conductive material films superimposed on the drawing lines while interposing the interlayer insulating film can be minimized or prevented.

The portions of the conductive material films superimposed on the drawing lines while interposing the interlayer insulating film that are close to the peripheral portion of the interlayer insulating film have the width smaller than the width of the other portions. Thus, the interval between the adjacent conductive material films in the peripheral portion of the interlayer insulating film is greater, which minimizes or prevents a short circuit between the adjacent drawing lines in the peripheral portion of the interlayer insulating film due to the conductive material films superimposed on the drawing lines while interposing the interlayer insulating film.

The thickness of the portions in the peripheral portion of the interlayer insulating film between the plurality of drawing lines is smaller than the thickness of the portions of the interlayer insulating film superimposed on the plurality of drawing lines. With this configuration, when the conductive material films are formed on the interlayer insulating film by photolithography, the thickness of a photoresist material film formed on uneven surfaces in the peripheral portion of the interlayer insulating film can be made smaller. In other words, in a step of forming the photoresist material film on the interlayer insulating film, the photoresist material film is also formed on the uneven surfaces in the peripheral portion of the interlayer insulating film. The thickness of the photoresist material film on the uneven surfaces in the peripheral portion of the interlayer insulating film depends on the thickness of the interlayer insulating film. Thus, when the thickness of the portions of the interlayer insulating film between the drawing lines is smaller than the thickness of the other portions, the thickness of the photoresist material film between the drawing lines is smaller. The smaller thickness of the photoresist material film can prevent the photoresist material film from being insufficiently exposed in an exposure step. Accordingly, if the photoresist material film is positive, the photoresist material film is prevented from remaining between the drawing lines in a development step. Accordingly, the conductive material films are prevented from remaining between the drawing lines in a step of performing patterning on the conductive material films using the photoresist material film as a mask. As a result, a short circuit between the adjacent drawing lines due to the conductive material films is minimized or prevented.

### Brief Description of Drawings

Fig. 1 is an oblique external view schematically showing the configuration of a display panel substrate according to a preferred embodiment of the present invention.
Fig. 2 is a plan view schematically showing the configuration of pixels and lines in a display region.
Fig. 3 is an enlarged plan view of a portion of a terminal region of the display panel substrate according to the preferred embodiment of the present invention.
Fig. 4A is a cross-sectional view along the line A-A in Fig. 3, Fig. 4B is a cross-sectional view along the line B-B in Fig. 3, and Fig. 4C is a cross-sectional view along the line C-C in Fig. 3.
Figs. 5A to 5C are cross-sectional views schematically showing a given step in a method for forming electrode terminals, drawing lines, an interlayer insulating film, and other components. Fig. 5A corresponds to the cross-sectional view along the A-A line in Fig. 3, Fig. 5B corresponds to the cross-sectional view along the B-B line in Fig. 3, and Fig. 5C corresponds to the cross-sectional view along the C-C line in Fig. 3.
Figs. 6A to 6C are cross-sectional views schematically showing a given step in the method for forming the electrode terminals, the drawing lines, the interlayer insulating film, and other components. Fig. 6A corresponds to the cross-sectional view along the A-A line in Fig. 3, Fig. 6B corresponds to the cross-sectional view along the B-B line in Fig. 3, and Fig. 6C corresponds to the cross-sectional view along the C-C line in Fig. 3.
Figs. 7A to 7C are cross-sectional views schematically showing a given step in the method for forming the electrode terminals, the drawing lines, the interlayer insulating film, and other components. Fig. 7A corresponds to the cross-sectional view along the A-A line in Fig. 3, Fig. 7B corresponds to the cross-sectional view along the B-B line in Fig. 3, and Fig. 7C corresponds to the cross-sectional view along the C-C line in Fig. 3.
Figs. 8A to 8C are cross-sectional views schematically showing a given step in the method for forming the electrode terminals, the drawing lines, the interlayer insulating film, and other components. Fig. 8A corresponds to the cross-sectional view along the A-A line in Fig. 3, Fig. 8B corresponds to the cross-sectional view along the B-B line in Fig. 3, and Fig. 8C corresponds to the cross-sectional view along the C-C line in Fig. 3.
Figs. 9A to 9C are cross-sectional views schematically showing a given step in the method for forming the electrode terminals, the drawing lines, the interlayer insulating film, and other components. Fig. 9A corresponds to the cross-sectional view along the A-A line in Fig. 3, Fig. 9B corresponds to the cross-sectional view along the B-B line in Fig. 3, and Fig. 9C corresponds to the cross-sectional view along the C-C line in Fig. 3.
Figs. 10A to 10C are cross-sectional views schematically showing a given step in the method for forming the electrode terminals, the drawing lines, the interlayer insulating film, and other components. Fig. 10A corresponds to the cross-sectional view along the A-A line in Fig. 3, Fig. 10B corresponds to the cross-sectional view along the B-B line in Fig. 3, and Fig. 10C corresponds to the cross-sectional view along the C-C line in Fig. 3.
Figs. 11A to 11C are cross-sectional views schematically showing a given step in the method for forming the electrode terminals, the drawing lines, the interlayer insulating film, and other components. Fig. 11A corresponds to the cross-sectional view along the A-A line in Fig. 3, Fig. 11B corresponds to the cross-sectional view along the B-B line in Fig. 3, and Fig. 11C corresponds to the cross-sectional view along the C-C line in Fig. 3.
Figs. 12A to 12C are cross-sectional views schematically showing a given step in the method for forming the electrode terminals, the drawing lines, the interlayer insulating film, and other components. Fig. 12A corresponds to the cross-sectional view along the A-A line in Fig. 3, Fig. 12B corresponds to the cross-sectional view along the B-B line in Fig. 3, and Fig. 12C corresponds to the cross-sectional view along the C-C line in Fig. 3.
Figs. 13A to 13C are cross-sectional views schematically showing a given step in the method for forming the electrode terminals, the drawing lines, the interlayer insulating film, and other components. Fig. 13A corresponds to the cross-sectional view along the A-A line in Fig. 3, Fig. 13B corresponds to the cross-sectional view along the B-B line in Fig. 3, and Fig. 13C corresponds to the cross-sectional view along the C-C line in Fig. 3.
Figs. 14A to 14C are cross-sectional views schematically showing a given step in a method for producing the display panel substrate according to the preferred embodiment of the present invention.
Figs. 15A to 15C are cross-sectional views schematically showing a given step in the method for producing the display panel substrate according to the preferred embodiment of the present invention.
Figs. 16A to 16C are cross-sectional views schematically showing a given step in the method for producing the display panel substrate according to the preferred embodiment of the present invention.
Figs. 17A to 17C are cross-sectional views schematically showing a given step in the method for producing the display panel substrate according to the preferred embodiment of the present invention.
Figs. 18A to 18C are cross-sectional views schematically showing a given step in the method for producing the display panel substrate according to the preferred embodiment of the present invention.
Figs. 19A to 19C are cross-sectional views schematically showing a given step in the method for producing the display panel substrate according to the preferred embodiment of the present invention.
Figs. 20A to 20C are views schematically showing the configuration of a color filter. Fig. 20A is a perspective view schematically showing the overall structure of the color filter. Fig. 20B is a plan view of the configuration of one pixel in the color filter. Fig. 20C is a cross-sectional view showing the cross-sectional structure of the pixel along the line F-F in Fig. 20B.
Fig. 21 is a cross-sectional view schematically showing the cross-sectional structure of a portion of a display panel according to the preferred embodiment of the present invention.

### Description of Embodiments

A detailed description of preferred embodiments of the present invention will now be provided with reference to the accompanying drawings. A display panel substrate according to the preferred embodiments of the present invention is a TFT array substrate that is used in an active matrix liquid crystal display panel.

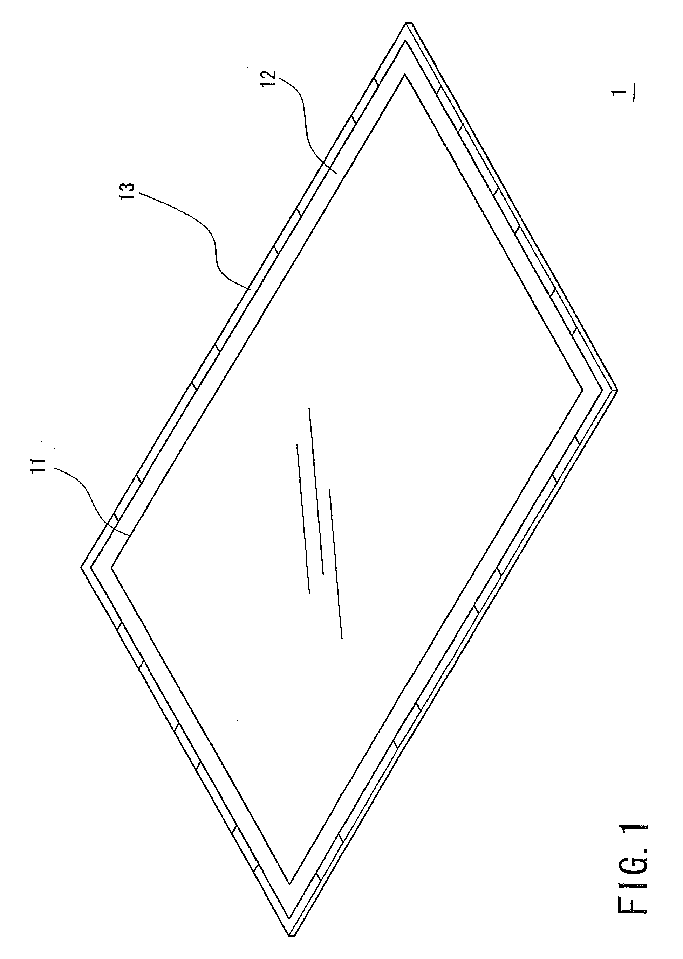

Fig. 1 is an oblique external view schematically showing the configuration of a display panel substrate 1 according to the preferred embodiment of the present invention. As shown in Fig. 1, the display panel substrate 1 includes a display region (active region) 11. A panel frame region 12 is provided to the outside of the display region 11 and surrounds the display region 11.

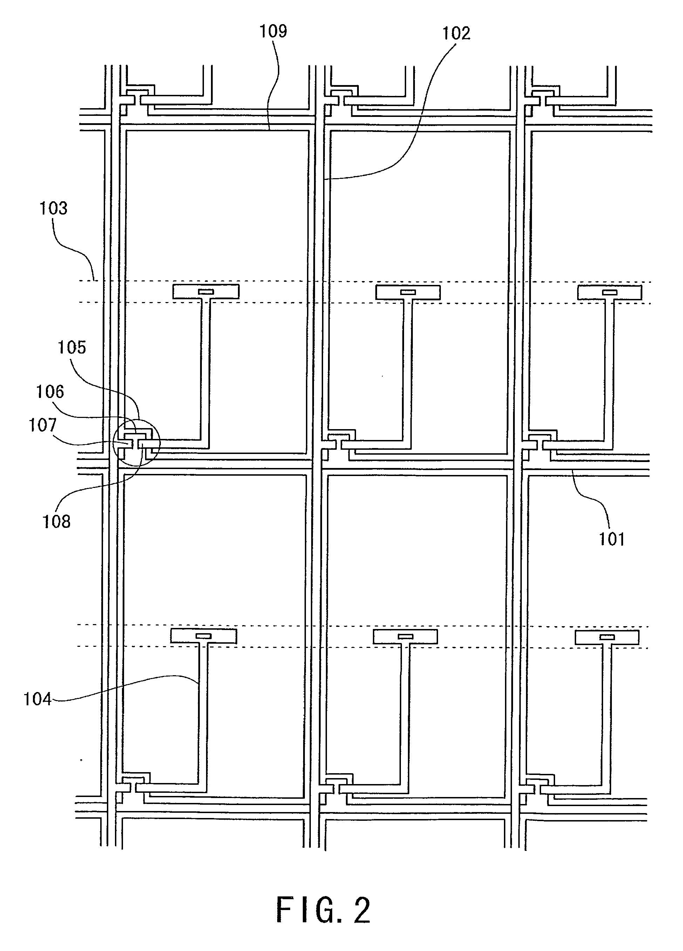

Fig. 2 is a plan view schematically showing the configuration of pixels and lines in the display region 11. As shown in Fig. 2, the display region 11 has a plurality of pixels arranged in a matrix. The pixels each include pixel electrodes 109 and switching elements (e.g., thin film transistors (TFTs)) 105 arranged to drive the pixel electrodes 109. The pixel electrodes 109 and drain electrodes 108 of the switching elements 105 are electrically continuous through drain lines 104. It should be noted that the pixel electrodes 109 may include slits arranged to control alignment of liquid crystals, which is omitted from illustration in Fig. 2.

In the display region 11, a plurality of scanning lines (gate bus lines) 101 are provided almost parallel to one another. Respectively between the scanning lines 101, auxiliary capacitance lines (storage capacitor lines) 103 are provided almost parallel to the scanning lines 101. A plurality of data lines (source bus lines) 102 are provided almost parallel to one another and almost perpendicular to the scanning lines 101 and the auxiliary capacitance lines 103.

In proximity to intersecting points of the scanning lines 101 and the data lines 102, the switching elements 105 arranged to drive the pixel electrodes 109 are provided. The switching elements 105 each include gate electrodes 106, source electrodes 107, and the drain electrodes 108. The gate electrodes 106 are electrically continuous to the scanning lines 101. The source electrodes 107 are electrically continuous to the data lines 102. The drain electrodes 108 are electrically continuous to the pixel electrodes 109 through the drain lines 104. The auxiliary capacitance lines 103 provide auxiliary capacitances (storage capacitors) to the pixel electrodes 109. This configuration allows the scanning lines 101 to transfer given data signals (selective pulses) to the gate electrodes 106 of the switching elements 105. This configuration also allows the data lines 102 to transfer given data signals to the source electrodes 107 of the switching elements 105.

The description continues referring to Fig. 1 again. The panel frame region 12 surrounds the display region 11. A terminal region 13 is provided at the periphery of the panel frame region 12. The terminal region 13 is provided for connecting a TCP (Tape Carrier Package) on which driver ICs (or driver LSIs) are provided, and an anisotropic conductive film (ACF) is bonded to the terminal region 13.

Electrode terminals 121 are provided in the terminal region 13. The electrode terminals 121 are terminals that are electrically connected to lines or terminals on the TCP (Tape Carrier Package) on which the driver ICs (or the driver LSIs) are provided. The electrode terminals 121 are lands that have a thin strip shape and are made from an electrically conductive material. The electrode terminals 121 are provided parallel to one another at given intervals.

In the panel frame region 12 other than the terminal region 13, lines 122 arranged to make the electrode terminals 121 electrically continuous to the scanning lines 101, the data lines 102, and the auxiliary capacitance lines 103 in the display region 11 are provided (the lines 122 are called "drawing lines 122" for the purpose of explanation).

The anisotropic conductive film is bonded to the terminal region 13, and the bonded anisotropic conductive film secures the TCP on which the drivers ICs are provided to the terminal region 13. When the TCP is secured to the terminal region 13 by the anisotropic conductive film, the lines and the terminals on the TCP are electrically continuous to the electrode terminals 121 in the terminal region 13. This configuration allows given signals generated by the driver ICs on the TCP to be transferred to given lines (the scanning lines 101, the auxiliary capacitance lines 103, and the data lines 102) in the display region 11 through the electrode terminals 121 and the drawing lines 122 in the panel frame region 12.

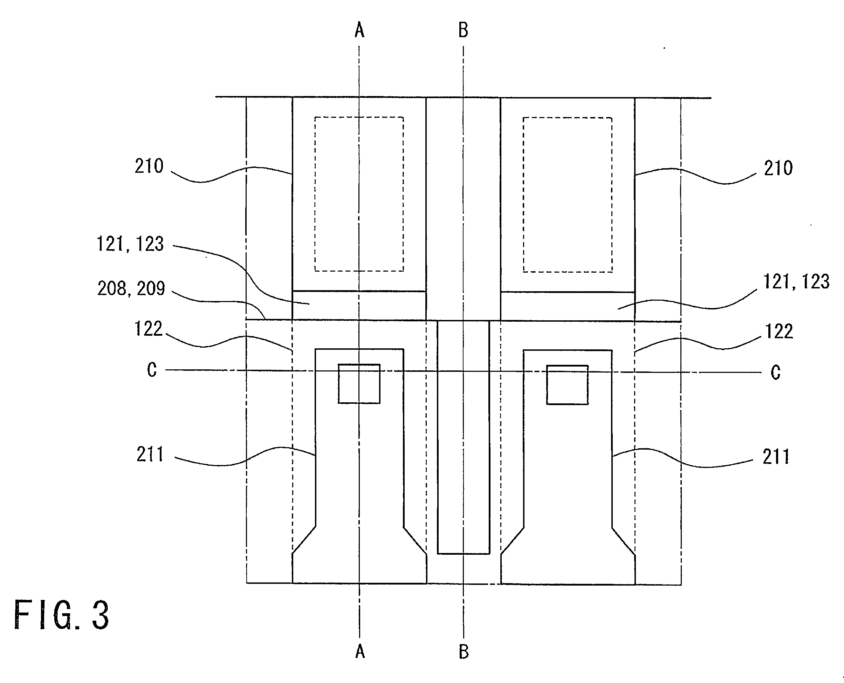

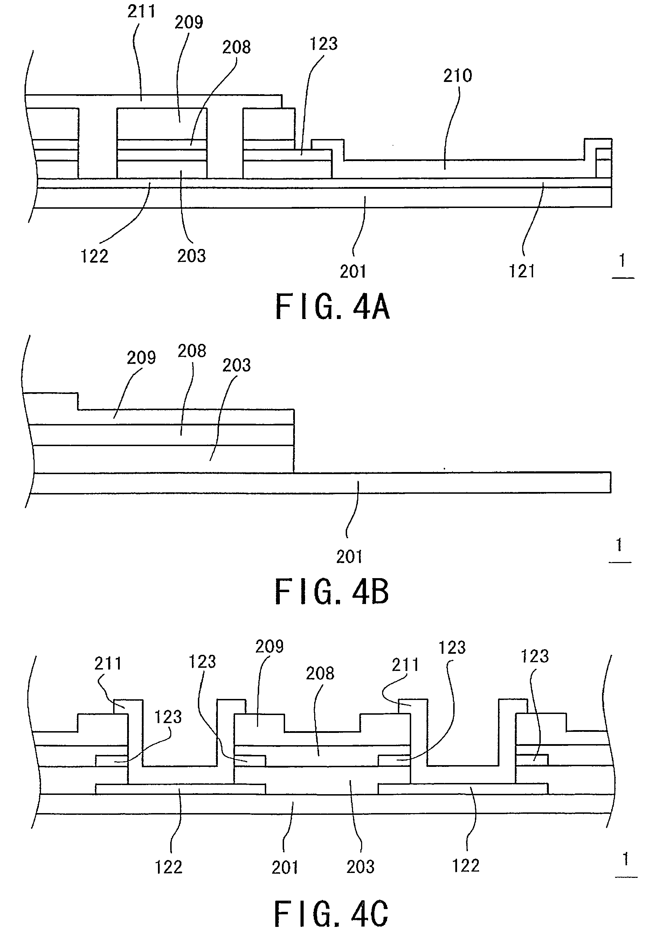

Fig. 3 is an enlarged plan view of a portion of the terminal region 13 of the display panel substrate 1 according to the preferred embodiment of the present invention. Fig. 4A is a cross-sectional view along the line A-A in Fig. 3, Fig. 4B is a cross-sectional view along the line B-B in Fig. 3, and Fig. 4C is a cross-sectional view along the line C-C in Fig. 3.

As shown in Fig. 3, in the panel frame region 12 of the display panel substrate 1 according to the preferred embodiment of the present invention, the strip-shaped electrode terminals 121 and the drawing lines 122 are provided almost parallel to one another at given intervals. The electrode terminals 121 are not covered with an interlayer insulating film 209, and the drawing lines 122 are covered with the interlayer insulating film 209. Conductive material films 210 are provided on the electrode terminals 121. Conductive material films 211 are provided on the interlayer insulating film 209 at portions superimposed on the drawing lines 122 while interposing the interlayer insulating film 209.

As shown in Figs. 4A and 4C, the electrode terminals 121 and the drawing lines 122 have a monolithic construction of the same material and are provided on the display panel substrate 1 according to the preferred embodiment of the present invention. The electrode terminals 121 and the drawing lines 122 are covered with a first insulating film 203. Sub lines 123 are provided on the first insulating film 203 so as to be superimposed on the electrode terminals 121 and the drawing lines 122 while interposing the first insulating film 203.

Openings (contact holes) are provided to the first insulating film 203 and the sub lines 123 in portions superimposed on the electrode terminals 121. The electrode terminals 121 are exposed through the openings. The conductive material films 210 are superimposed on the electrode terminals 121. To be specific, the conductive material films 210 are provided on the electrode terminals 121 exposed through the openings in the first insulating film 203 and the sub lines 123, and bridge the edges of the openings. Thus, the electrode terminals 121 and the sub lines 123 are electrically continuous through the conductive material films 210.

Openings (contact holes) are provided so as to pass through all of the first insulating film 203, the sub lines 123, and the interlayer insulating film 209 that are superimposed on the drawing lines 122. Thus, portions of the drawing lines 122 are exposed through the openings. The conductive material films 211 are provided on the interlayer insulating film 209 and are superimposed on the drawing lines 122 while interposing the first insulating film 203, the sub lines 123, and the interlayer insulating film 209. The conductive material films 211 are also provided inside the openings passing through the first insulating film 203, the sub lines 123, and the interlayer insulating film 209. Accordingly, the drawing lines 122 and the sub lines 123 are electrically continuous to one another through the conductive material films 211.

According to this configuration, given electrical signals may be transferred through the electrode terminals 121 and the drawing lines 122 and also through the sub lines 123 and the conductive material films 210 and 211, which achieves the same action and effect as decreasing electrical resistance by increasing the cross-sectional area of the electrode terminals 121 and the drawing lines 122. Thus, loss of electrical signals transferred through the electrode terminals 121 and the drawing lines 122 can be minimized.

As shown in Figs. 3 and 4A, the conducive material films 210 are not provided in a peripheral portion of the interlayer insulating film 209. Thus, the conductive material films 210 formed on the electrode terminals 121 are physically separate from the conductive material films 211 formed on the interlayer insulating film 209. This configuration prevents a short circuit between the adjacent electrode terminals 121 due to the conductive material films 210 in the peripheral portion of the interlayer insulating film 209. This configuration also prevents a short circuit between the adjacent drawing lines 122 due to the conductive material films 211.

As shown in Figs. 4B and 4C, the thickness of portions of the interlayer insulating film 209 formed between the drawing lines 122 (i.e., portions not superimposed on the drawing lines 122) is smaller than the thickness of portions of the interlayer insulating film 209 formed on the drawing lines 122 (i.e., portions superimposed on the drawing lines 122). Thus, the thickness of the peripheral portion of the interlayer insulating film 209 is decreased in stepwise.

As shown in Fig. 3, portions of the conductive material films 211 formed on the interlayer insulating film 209 that are close to the thin portions of the interlayer insulating film 209 have a width smaller than a width of the other portions. On the side close to the display region 11, the width of the conductive material films 211 is substantially the same as the width of the drawing lines 122, and on the side close to the electrode terminals 121 (close to the thin portions of the interlayer insulating film 209) , the width of the conductive material films 211 is smaller than the width of the drawing lines 122. This configuration makes the interval between the adjacent conductive material films 211 in the peripheral portion of the interlayer insulating film 209 greater, which prevents a short circuit between the adjacent drawing lines 122 due to the conductive material films 211.

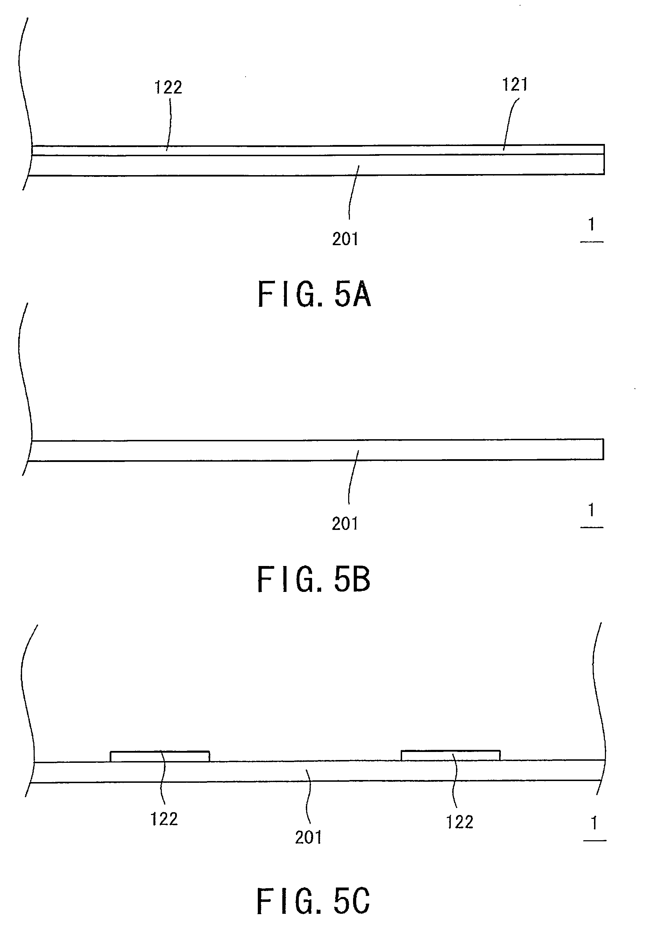

A description of a method for forming the electrode terminals 121, the drawing lines 121, the interlayer insulating film 209, and other components in the configuration described above will be provided. Figs. 5A to 13C are cross-sectional views schematically showing steps of the method for forming the electrode terminals 121, the drawing lines 121, the interlayer insulating film 209, and other components. The drawings labeled A among Figs. 5A to 13C correspond to the cross-sectional view along the A-A line in Fig. 3, the drawings labeled B among Figs. 5A to 13C correspond to the cross-sectional view along the B-B line in Fig. 3, and the drawings labeled C among Figs. 5A to 13C correspond to the cross-sectional view along the C-C line in Fig. 3.

As shown in Figs. 5A and 5B, the electrode terminals 121 and the drawing lines 122 are formed on the transparent substrate 201 preferably made of glass. To be specific, a single-layer or multilayer first conductor film preferably made from chromium, tungsten, molybdenum, or aluminum is formed on the transparent substrate 201. For the formation of the first conductor film, a known sputtering method may be used. The thickness of the first conductor film is not particularly limited and may be about 300 nm, for example. The formed first conductor film is subjected to patterning so as to have a pattern of the electrode terminals 121 and the drawing lines 122 preferably by photolithography. For the patterning of the first conductor film, wet etching may be used. As shown in Fig. 5B, the first conductor film is not formed between the electrode terminals 121 or between the drawing lines 122.

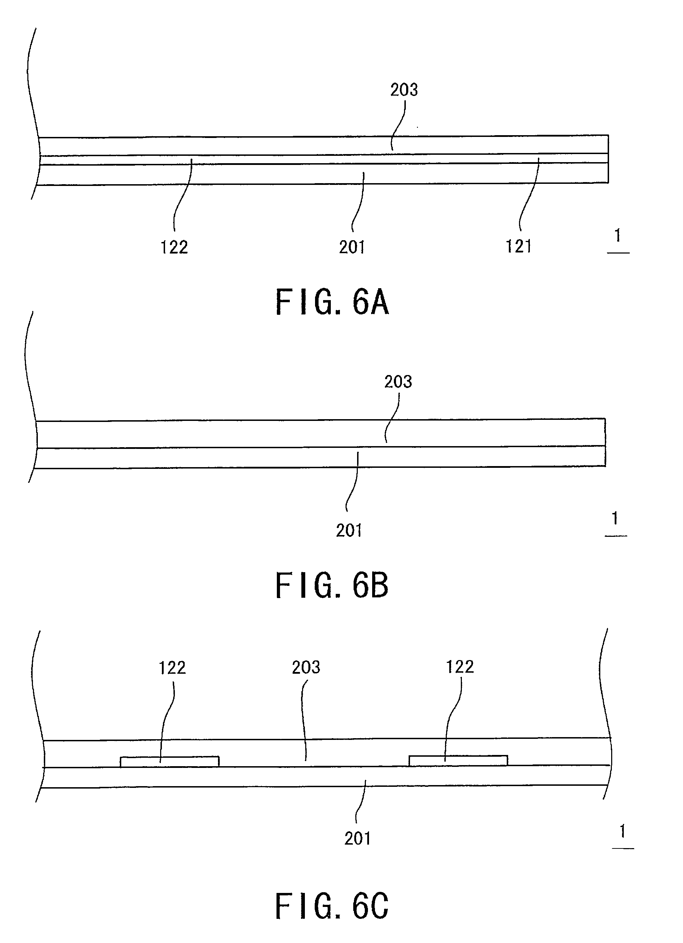

Next, the first insulating film 203 is formed on the transparent substrate 201 on which the electrode terminals 121 and the drawing lines 122 have been formed as shown in Figs. 6A to 6C. For the first insulating film 203, SiNx (silicon nitride) is preferably used. For the formation of the first insulating film 203, plasma CVD is preferably used. By forming the first insulating film 203, the electrode terminals 121 and the drawing lines 122 are covered with the first insulating film 203.

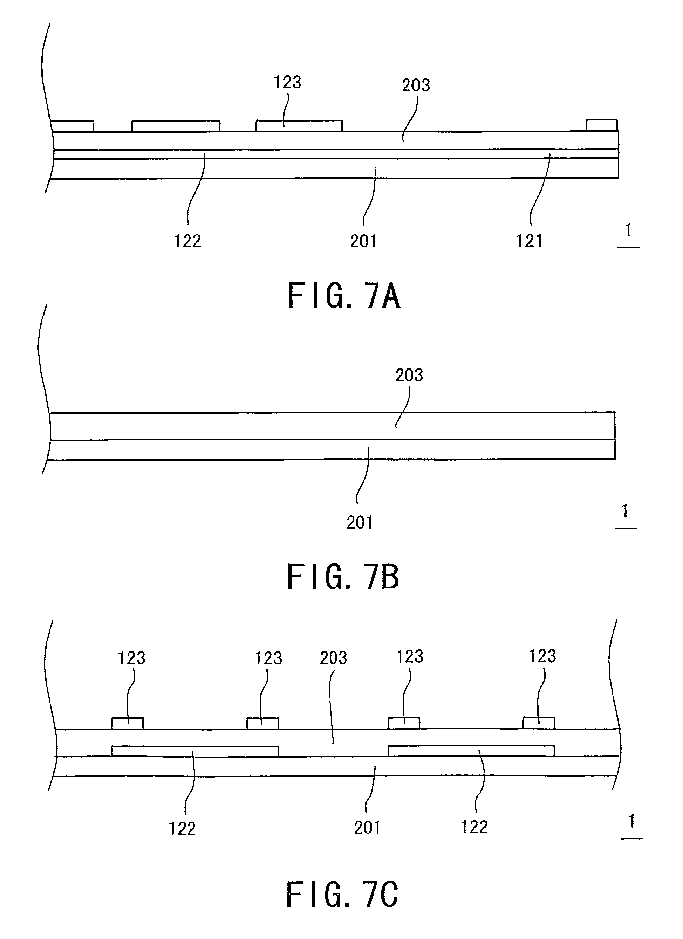

Next, the sub lines 123 are formed as shown in Figs. 7A and 7C. The sub lines 123 are superimposed on the electrode terminals 121 and the drawing lines 122. The openings (contact holes) are formed in the portions of the sub lines 123 superimposed on the electrode terminals 121, and the electrode terminals 121 are exposed through the openings. As shown in Fig. 7B, the sub lines 123 are not formed between the electrode terminals 121 or between the drawing lines 122.

To be specific, a conductor film that becomes the sub lines 123 (a second conductor film) is formed on the transparent substrate 201 having passed through the above described steps. The formed second conductor film is subjected to patterning into the sub lines 123 of a given pattern. The second conductor film may be a film of a multilayered structure preferably made from titanium, aluminum, chromium, or molybdenum. The method for forming the second conductor film is preferably sputtering. For the patterning of the second conductor film, dry etching using Cl₂ gas or BCl₃ gas or wet etching using phosphoric acid, acetic acid, or nitric acid may be used.

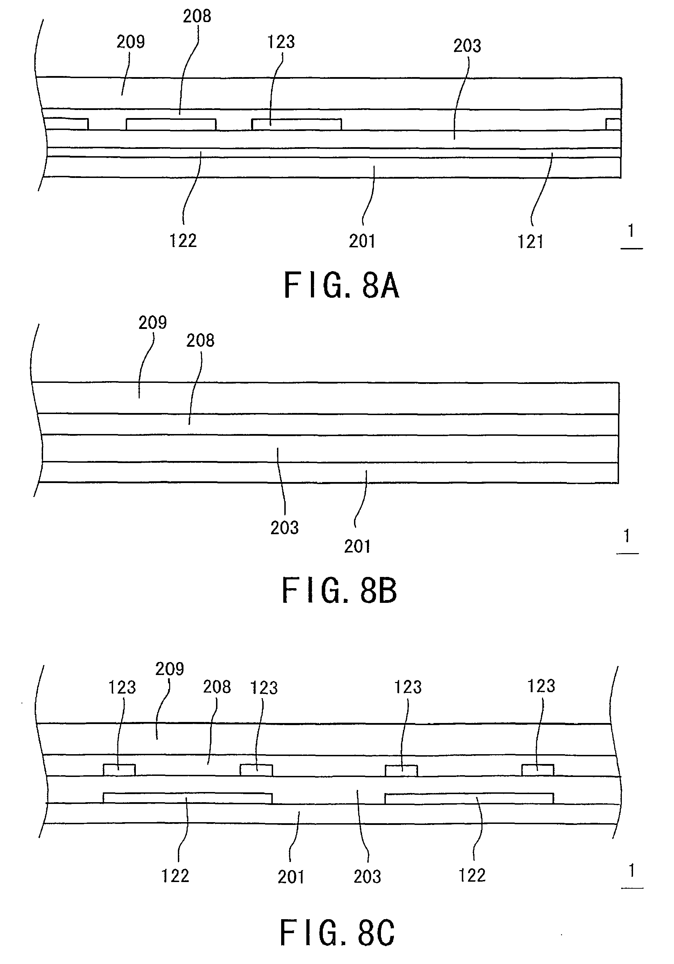

Then, a second insulating film 208 is formed on the transparent substrate 201 having passed through the above described steps, and the interlayer insulating film 209 is formed on the second insulating film 208, as shown in Figs. 8A to 8C. Thus, the electrode terminals 121 and the drawing lines 122 are covered with the second insulating film 208 and the interlayer insulating film 209. For the second insulating film 208, SiNx (silicon nitride) is preferably used. For the formation of the second insulating film 208, plasma CVD is preferably used. For the interlayer insulating film 209, an acrylic photo sensitive resin may be used. For the formation of the interlayer insulating film 209, a method for applying the material of the interlayer insulating film 209 with the use of a spin coater or a slit coater may be used.

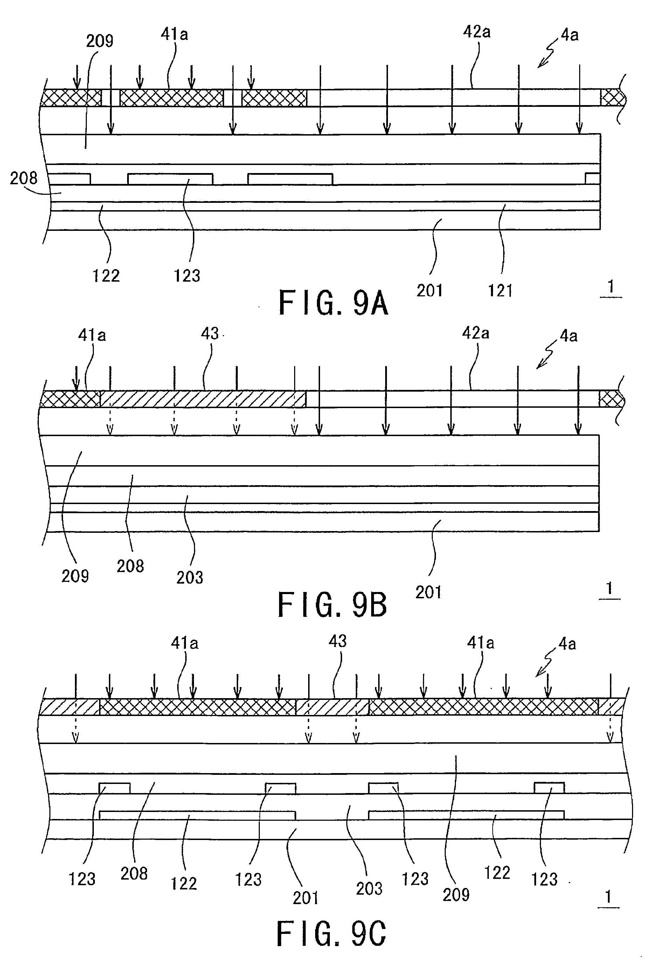

Then, the formed interlayer insulating film 209 is subjected to exposure with the use of a photomask 4a as shown in Figs. 9A to 9C.

The photomask 4a has light transmitting regions 42a, light shielding regions 41a, and halftone regions 43 of a given pattern. To be specific, if the interlayer insulating film 209 is made from a positive photoresist material, the light transmitting regions 42a are provided at positions corresponding to regions where the electrode terminals 121 are to be formed, the light shielding regions 41a are provided at positions corresponding to regions where the drawing lines 122 are to be formed, and the halftone regions 43 are provided at positions corresponding to the portions between the drawing lines 122.

Thus, by using the photomask 4a described above, the portions of the formed interlayer insulating film 209 superimposed on the electrode terminals 121 are irradiated with light energy through the light transmitting regions 42a, and the portions of the formed interlayer insulating film 209 superimposed on the drawing lines 122 are not irradiated with light energy. The portions of the formed interlayer insulating film 209 between the drawing lines 122 are irradiated with light energy through the halftone regions 32. Light energy irradiating through the halftone regions 32 is weaker than light energy irradiating through the light transmitting regions 42a.

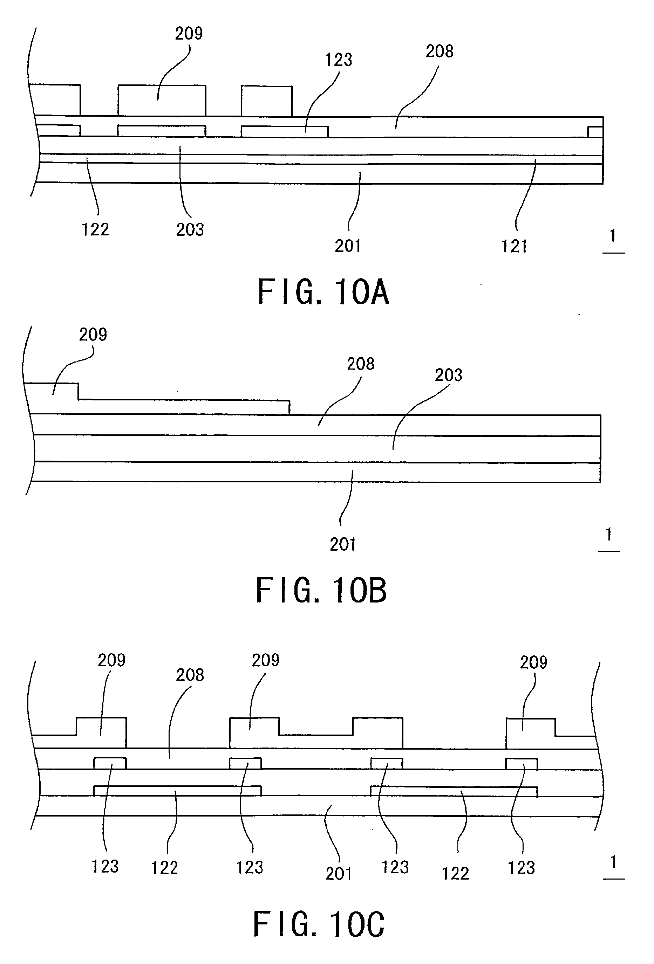

Then, the exposed photoresist material film is subjected to development as shown in Figs. 10A to 10C. Figs. 10A to 10C show the shape of the interlayer insulating film 209 after the development. After the development, portions of the photoresist material film irradiated with light energy through the light transmitting regions 42a of the photomask 4a are removed. As a result, the portions of the formed interlayer insulating film 209 covering the regions of the electrode terminals 121 are removed, and the electrode terminals 121 are exposed. The thickness of the portions of the interlayer insulating film 209 irradiated with light energy through the halftone regions 43 of the photomask 4a is small. As a result, the thickness of the portions of the interlayer insulating film 209 between the drawing lines 122 is smaller than the thickness of the other portions of the interlayer insulating film 209 (light shielded portions) (see Figs. 10B and 10C). Accordingly, depressed surfaces having the smaller thickness are formed between the drawing lines 122.

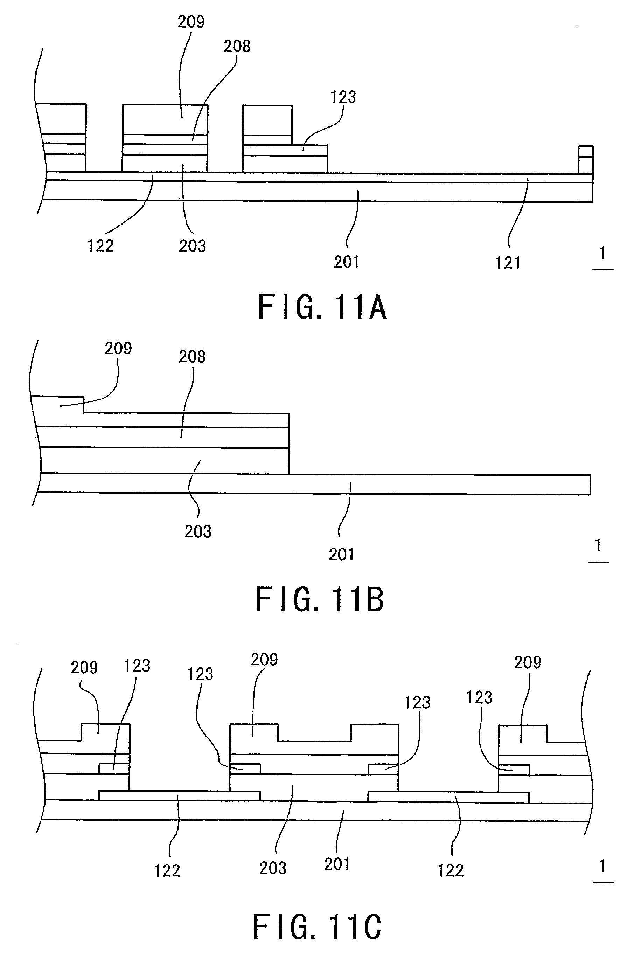

The patterning of the second insulating film 208 is performed by using the interlayer insulating film 209 having been subjected to the patterning as shown in Figs. 11A to 11C. In this patterning, the patterning of the first insulating film 203 is simultaneously performed. For the patterning of the first insulating film 203 and the second insulating film 208, dry etching using CF₄+O₂ gas or SF₆+O₂ gas may be used.

By this patterning, portions of the second insulating film 208 superimposed on the electrode terminals 121 and portions of the second insulating film 208 exposed through the openings (contact holes) in the interlayer insulating film 209 are removed. In addition, the portions of the first insulating film 203 exposed through the openings in the sub lines 123 are removed. Accordingly, the openings pass through the interlayer insulating film 209, the second insulating film 208, the sub lines 123, and the first insulating film 203, so that the given portions of the drawing lines 122 are exposed through the openings. The electrode terminals 121 are exposed through the openings in the sub lines 123.

Then, a third conductor film 212 is formed. For the third conductor film 212, ITO (Indium Tin Oxide) about 100 nm in thickness is preferably used. The formation of the third conductor film 212 is as follows. First, the third insulating film 212 is deposited on the transparent substrate 201 having passed through the above described steps preferably by sputtering. A photoresist material film 213 is formed on the formed third conductor film 212. The formation of the photoresist material film 213 is performed by using a spin coater or a slit coater.

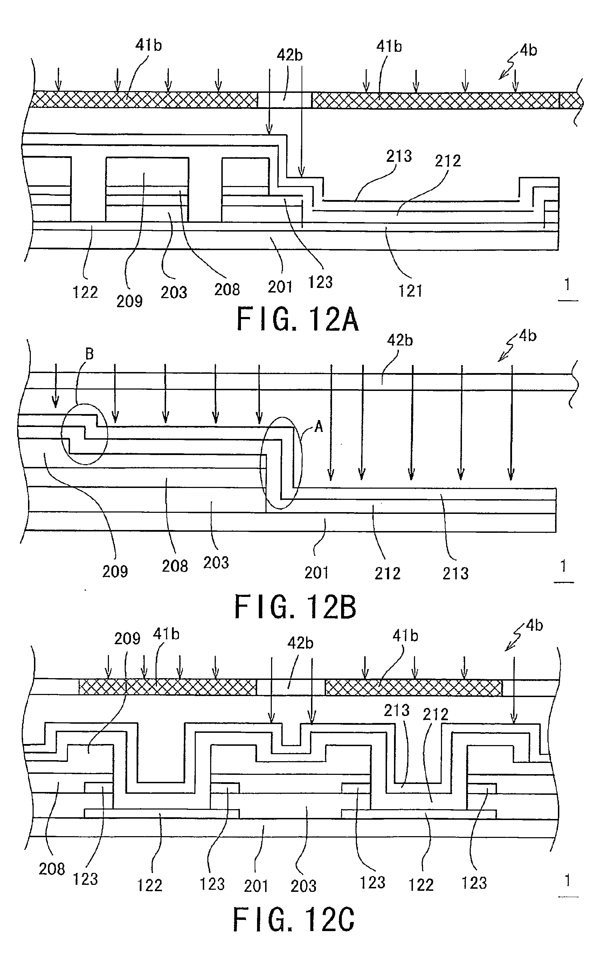

The formed photoresist material film 213 is subjected to exposure by using a photomask 4b having light transmitting regions 42b and light shielding regions 41b of a given pattern. Figs. 12A to 12C are views schematically showing steps of subjecting the photoresist material film 213 to exposure. The arrows shown in Figs. 12A to 12C schematically depict irradiating light energy.

If the photoresist material film 213 is positive, portions between the electrode terminals 121, between the drawing lines 122, and in the peripheral portion of the interlayer insulating film 209 are irradiated with light energy through the light transmitting regions 42b of the photomask 4b. Portions superimposed on the electrode terminals 121 and on the drawing lines 122 are shielded by the light shielding regions 41b of the photomask 4b.

As shown in Figs. 12A to 12C, the photoresist material film 213 is also formed on the uneven surfaces in the peripheral portion of the interlayer insulating film 209 (e.g., the portion A and the portion B in Fig. 12B). The thickness of the photoresist material film 213 formed on the uneven surfaces in the peripheral portion of the interlayer insulating film 209 depends on the height of the uneven surfaces in the peripheral portion of the interlayer insulating film 209. In the preferred embodiment of the present invention, the thickness of the portions in the peripheral portion of the interlayer insulating film 209 between the drawing lines 122 is smaller than the thickness of the other portions (see Fig. 12B). Therefore, the thickness of the photoresist material film 213 formed on the uneven surfaces in the peripheral portion of the interlayer insulating film 209 can be made smaller. Thus, insufficient exposure on the uneven surfaces (especially the portion A) can be prevented.

The photoresist material film 213 having been subjected to the exposure is subjected to development. By subjecting the photoresist material film 213 to development, the portions irradiated with light energy are removed. To be specific, the portions of the photoresist material film 213 between the electrode terminals 121, between the drawing lines 122, and covering the peripheral portion of the interlayer insulating film 209 are removed. Accordingly, insufficient exposure on the photoresist material film 213 formed on the uneven surfaces in the peripheral portion of the interlayer insulating film 209 is prevented. By performing the development, the photoresist material film 213 formed on the uneven surfaces in the peripheral portion of the interlayer insulating film 209 is completely removed and does not remain.

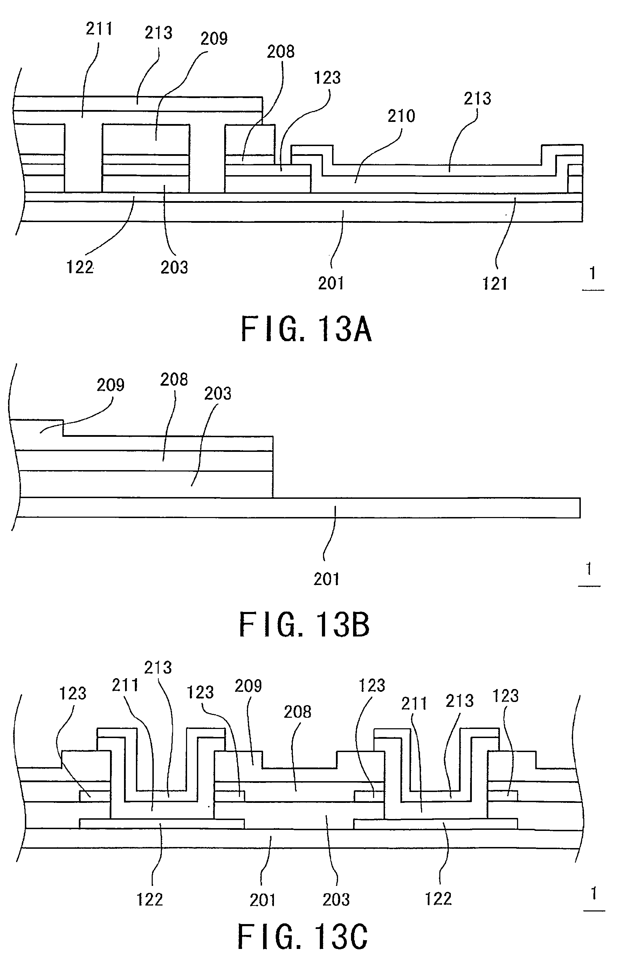

Then, the third conductor film 212 is subjected to patterning by using the photoresist material film 213 having passed through the development as a mask. Figs. 13A to 13C show the third conductor film 212 after the patterning. For the patterning of the third conductor film 212, etching is preferably used. By performing the patterning, portions of the third conductor film 212 covered with the photoresist material film 213 remain, and the other portions are removed. To be specific, portions of the third conductor film 212 superimposed on the electrode terminals 121 and on the drawing lines 122 remain, and the other portions of the third conductor film 212 (i.e., portions between the electrode terminals 121, between the drawing lines 122, and in the peripheral portion of the interlayer insulating film 209) are removed.

Because the photoresist material film 213 formed on the uneven surfaces in the peripheral portion of the interlayer insulting films 209 is completely removed, the conductive material films formed on the uneven surfaces in the peripheral portion of the interlayer insulting films 209 can also be completely removed. Because the conductive material films do not remain on the uneven surfaces in the peripheral portion of the interlayer insulating film 209, a short circuit between the adjacent drawing lines 122 or a short circuit between the adjacent electrode terminals 121 due to the conductive material films can be prevented.

The photoresist material film 213 is then removed. After the removal of the photoresist material film 213, the terminal region 13 of the display panel substrate 1 according to the preferred embodiment of the present invention has the configuration shown in Fig. 4.

Through the above described steps, the conductive material films 210 are formed on the electrode terminals 121, and the conductive material films 211 are formed in the portions superimposed on the drawing lines 122 while interposing the interlayer insulating film 209.

Next, a description of the whole process of a method for producing the display panel substrate 1 according to the preferred embodiment of the present invention will be provided.

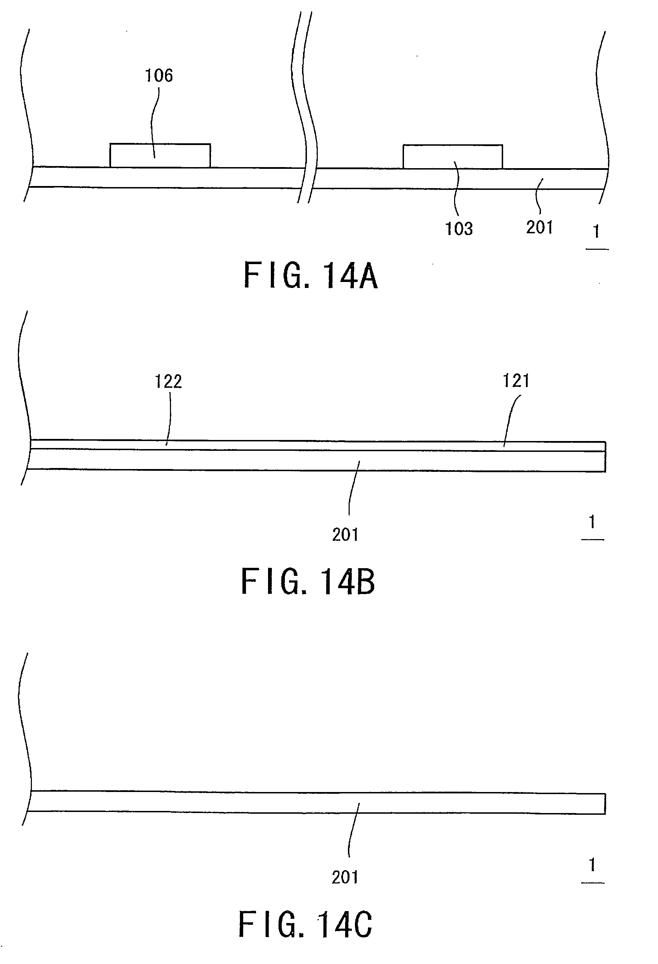

Figs. 14A to 19C are cross-sectional views schematically showing steps of the method for producing the display panel substrate 1 according to the preferred embodiment of the present invention. The drawings labeled A among Figs. 14A to 19C are views showing the steps of producing pixels and bus lines in the display region 11. The drawings labeled B or C among Figs. 14A to 19C are views showing the steps of forming the electrode terminals 121 and the drawing lines 122 in the panel frame region 12. The drawings labeled B among Figs. 14A to 19C correspond to the cross-sectional views along the line A-A in Fig. 3, and the drawings labeled C among Figs. 14A to 19C correspond to the cross-sectional views along the line B-B in Fig. 3. The drawings labeled A among Figs. 14A to 19C are views schematically showing the cross-sectional structure of the display region 11 of the display panel substrate 1 according to the preferred embodiment of the present invention and are not cross-sectional views in specific cross-section.

First, as shown in Fig. 14A, the scanning lines 101, the auxiliary capacitance lines 103, and the gate electrodes 106 of the switching elements 105 are formed in the display region 11 of the transparent substrate 201 preferably made of glass. As shown in Fig. 14B, the electrode terminals 121 and the drawing lines 122 are formed in the panel frame region 12 in this step. As shown in Fig. 14C, nothing is formed between the electrode terminals 121 and between the drawing lines 122 in this step.

To be specific, a single-layered or multilayered conductor film preferably made of chromium, tungsten, molybdenum, or aluminum (the first conductor film) is formed on the transparent substrate 201. For the formation of the first conductor film, sputtering is preferably used. Although the thickness of the first conductor film is not particularly limited, a thickness of about 300 nm is preferably used.

The formed first conductor film is subjected to patterning into the scanning lines 101, the auxiliary capacitance lines 103, and the gate electrodes 106 of the switching elements 105 as shown in Fig. 14A. In the panel frame region 12, the first conductor film is subjected to patterning into the electrode terminals 121 and the drawing lines 122 as shown in Fig. 14B. For the patterning of the first conductor film, wet etching is preferably used. For example, if the first conductor film is made from chromium, wet etching using a solution of (NH₄)₂[Ce(NH₃)₆]+HNO₃+H₂O is preferably used.

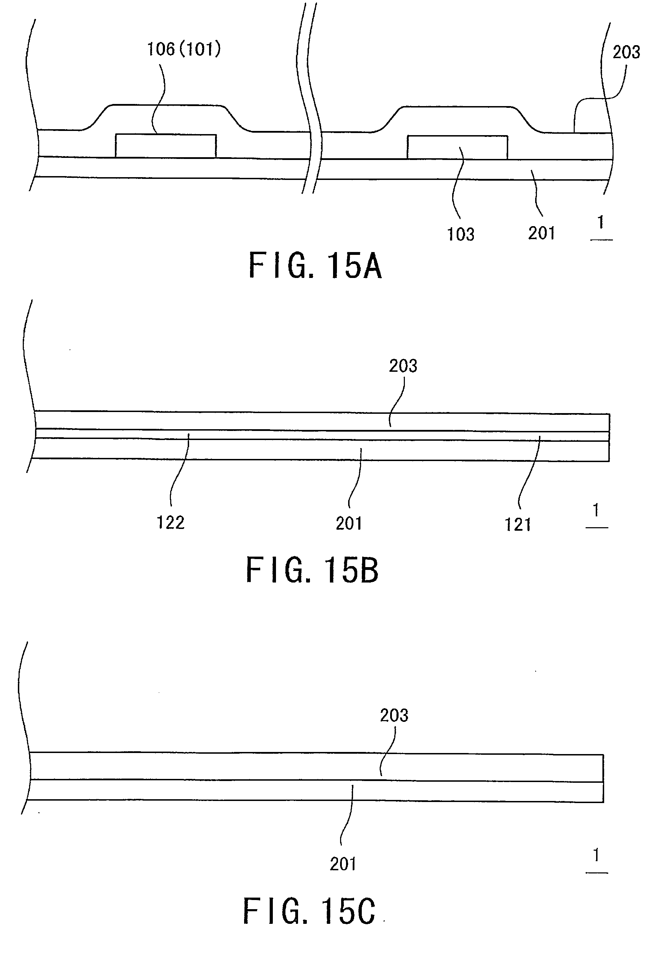

Next, the first insulating film 203 is formed on the transparent substrate 201 having passed through the above described steps as shown in Figs. 15A to 15C. For the first insulating film 203, SiNx (silicon nitride) about 300 nm in thickness is preferably used. The first insulating film 203 is preferably formed by plasma CVD. When the first insulating film 203 is formed, the scanning lines 101, the auxiliary capacitance lines 103, and the gate electrodes 106 of the switching elements 105 are covered with the first insulating film 203 in the display region 11 as shown in Fig. 15A. In the display region 11, the first insulating film 203 defines a gate insulating film. In the panel frame region 12, the electrode terminals 121 and the drawing lines 122 are covered with the first insulating film 203 as shown in Fig. 15B.

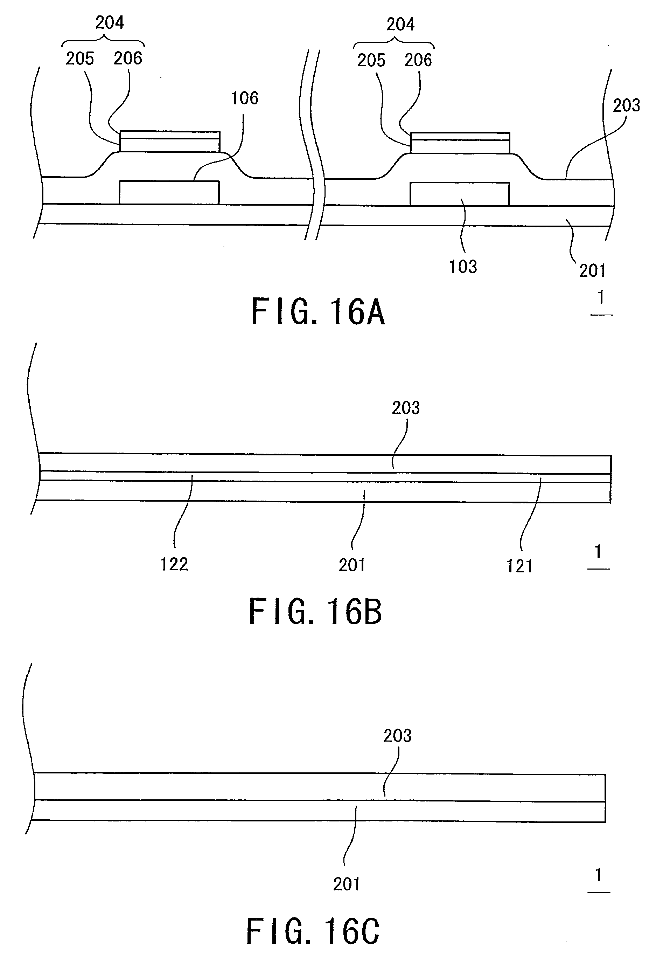

Then, semiconductor films 204 having a given shape is formed at given positions on the first insulating film 203 in the display region 11 as shown in Fig. 16A. To be specific, the semiconductor films 204 are formed at positions superimposed on the gate electrodes 106 while interposing the first insulating film 203 and at positions superimposed on the auxiliary capacitance lines 103 while interposing the first insulating film 203. The semiconductor films 204 each have a two-layer structure consisting of a first sub semiconductor film 205 and a second sub semiconductor film 206. For the first sub semiconductor films 205, amorphous silicon about 100 nm in thickness is preferably used. For the sub semiconductor films 206, n⁺ amorphous silicon about 20 nm in thickness is preferably used.

The first sub semiconductor films 205 function as etching stopper layers in the step of patterning the data lines 102 and the drain lines 104 by etching. The second sub semiconductor films 206 are provided for achieving a favorable ohmic contact with the source electrodes 107 and the drain electrodes 108 that are to be formed in subsequent steps.

The semiconductor films 204 (the first sub semiconductor films 205 and the second sub semiconductor films 206) are prepared by plasma CVD and photolithography.

First, a material of the semiconductor films 204 (the first sub semiconductor films 205 and the second sub semiconductor films 206) is deposited by plasma CVD on the transparent substrate 201 having passed through the above described steps. The formed semiconductor films 204 (the first sub semiconductor films 205 and the second sub semiconductor films 206) are then subjected to patterning so as to have given shapes preferably by photolithography. To be specific, a photoresist material layer is formed on the semiconductor films 204. For the formation of the photoresist material layer, a spin coater is preferably used. Then, the formed photoresist material layer is subjected to exposure by using a photomask, and is then subjected to development. Thus, the photoresist material layer of a given pattern is formed on the semiconductor layers 204 in the display region 11.

Then, the patterning of the semiconductor films 204 is performed by using the photoresist material layer having been subjected to the patterning as a mask. For the patterning, wet etching using a solution of HF+HNO₃ or dry etching using Cl₂ gas and BCl₃ gas is preferably used. Accordingly, the semiconductor films 204 (the first sub semiconductor films 205 and the second sub semiconductor films 206) are superimposed on the gate electrodes 106 and the auxiliary capacitance lines 103 while interposing the first insulating film 203.

In this step, the semiconductor films 204 are not formed in the panel display region 12 as shown in Figs. 16B and 16C.

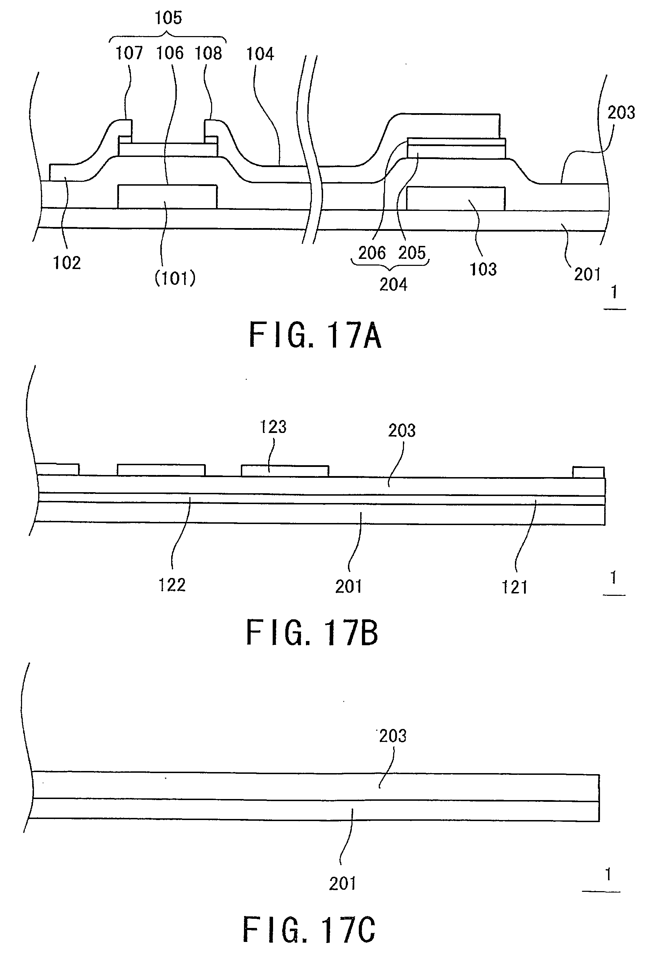

Next, the data lines 102, the drain lines 104, and the source electrodes 107 and the drain electrodes 108 of the switching elements 105 are formed in the display region 11 as shown in Fig. 17A. In this step, the sub lines 123 are simultaneously formed on the first insulating film 203 at positions superimposed on the electrode terminals 121 and the drain lines 12 in the panel frame region 12 as shown in Fig. 17B. The sub lines 123 are not formed between the electrode terminals 121 or between the drawing lines 122 as shown in Fig. 17C.

To be specific, a conductor film that is a material of the data lines 102, the drain lines 104, the source electrodes 107 and the drain electrodes 108 of the switching elements 105, and the sub lines 123 (i.e., the second conductor film) is formed on the transparent substrate 201 having passed through the above described steps. For the formation of the second conductor film, sputtering is preferably used. Then, the formed second conductor film is subjected to patterning to have a given shape. For the patterning of the second conductor film, dry etching using Cl₂ gas or BCl₃ gas or wet etching using phosphoric acid, acetic acid, or nitric acid may be used.

By performing this patterning, the data lines 102, the drain lines 104, and the source electrodes 107 and the drain electrodes 108 of the switching elements 105 that are made from the second conductor film are formed in the display region 11. The sub lines 123 made from the second conductor film are formed in the panel frame region 12. In this patterning, etching of the second sub semiconductor films 206 is performed by using the first sub semiconductor films 205 as the etching stopper layers.

The second conductor film has a multilayered structure preferably made from titanium, aluminum, chromium, or molybdenum. The second conductor film of the display panel substrate 1 according to the preferred embodiment of the present invention has a two-layered structure. In other words, the second conductor film has a two-layered structure consisting of a first sub conductor film close to the transparent substrate 201 and a second sub conductor film close to the pixel electrode 109. For the first sub conductor film, titanium is preferably used. For the second sub conductor film, aluminum is preferably used.

Having passed through the above described steps, the switching elements 105 (the gate electrodes 106, the source electrodes 107, and the drain electrodes 108), the data lines 102, the scanning lines 101, the drain lines 104, and the auxiliary capacitance lines 103 are formed in the display region 11 as shown in Fig. 17A. In addition, the electrode terminals 121, the drawing lines 122, and the sub lines 123 are formed in the panel frame region 12 as shown in Fig. 17B.

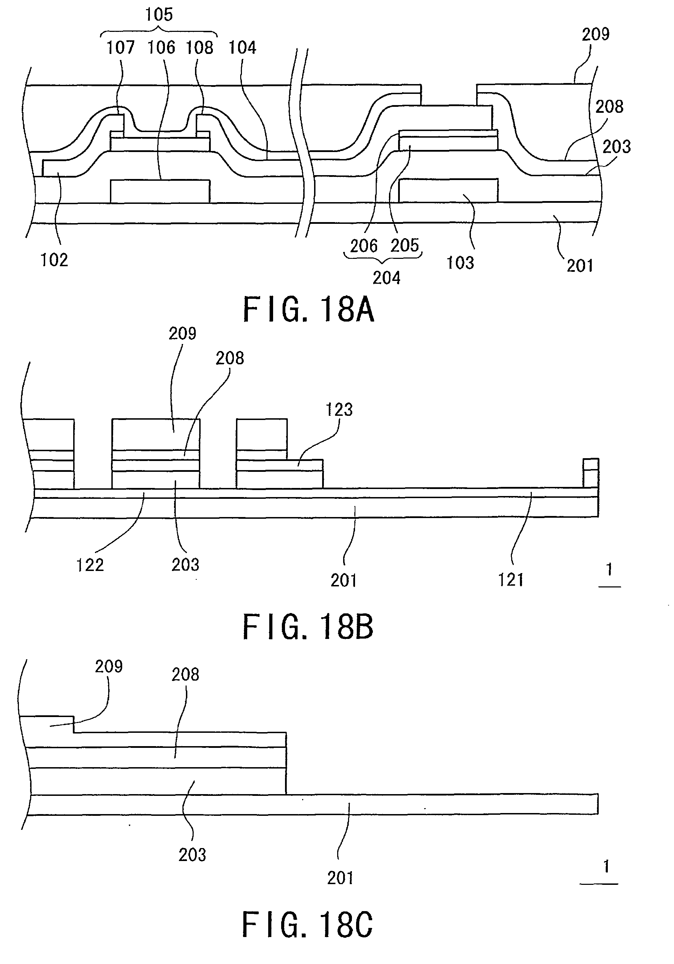

Next, the second insulating film 208 and the interlayer insulating film 209 are formed on the transparent substrate 201 having passed through the above described steps as shown in Figs. 18A to 18C. For the second insulating film 208, SiNx (silicon nitride) about 300 nm in thickness may be used. For the interlayer insulating film 209, an acrylic photosensitive resin is preferably used.

A description of a method for forming the second insulating film 208 and the interlayer insulating film 209 is provided. First, the second insulating film 208 is formed on the transparent substrate 201 having passed through the above described steps. Plasma CVD can be used in forming the second insulating film 208. Then, the interlayer insulating film 209 is formed on the formed second insulating film 208. In the formation of the interlayer insulating film 209, a photoresist material film is formed on the transparent substrate 201 preferably by using a spin coater.

The formed interlayer insulating film 209 is subjected to patterning into a given pattern by photolithography. By this patterning, in the display region 11, openings (contact holes) arranged to make the pixel electrodes 109 and the drain lines 104 electrically continuous are formed. In the panel frame region 12, the portions of the interlayer insulating film 209 superimposed on the electrode terminals 121 are removed. Openings (contact holes) arranged to electrically connect the drawing lines 122 and the sub lines 123 are formed. In the panel frame region 12, the thickness of the portions of the interlayer insulating film 209 between the drawing lines 122 is smaller than the thickness of the other portions.

If the photoresist material is positive, the portions where the openings are formed in the exposure step are irradiated with light energy, and the other portions where the interlayer insulating film 209 remains are shielded against light energy. In the panel frame region 12, the portions of the interlayer insulating film 209 superimposed on the electrode terminals 121 are irradiated with light energy, and the portions of the interlayer insulating film 209 superimposed on the drawing lines 122 are shielded against light energy. The portions between the drawing lines 122 are irradiated with light energy through the halftone regions 43 of the photomask 4a. In other words, the portions of the interlayer insulating film 209 between the drawing lines 122 are irradiated with weaker light energy as compared to the portions of the interlayer insulating film 209 superimposed on the electrode terminals 121.

When the interlayer insulating film 209 having been subjected to exposure are subjected to development, the portions irradiated with light energy are removed, and the shielded portions remain. The thickness of the portions of the interlayer insulating film 209 exposed through the halftone regions is smaller than the thickness of the shielded portions. Thus, the openings arranged to make the pixel electrodes 109 and the drain lines 104 electrically continuous are formed in the display region 11. In the panel frame region 12, the portions of the interlayer insulating film 209 superimposed on the electrode terminals 121 are removed. The thickness of the portions of the interlayer insulating film 209 between the drawing lines 122 is smaller than the thickness of the other portions.

After the patterning of the interlayer insulating film 209 and the removal of the given portions, the second insulating film 208 is exposed through the removed portions. By this patterning, the portions of the second insulating film 208 exposed through the interlayer insulating film 209 (the portions not covered with the interlayer insulating film 209) are removed. In this patterning, patterning of the first insulating film 203 is simultaneously performed. To be specific, in the panel frame region 12, the portions of the first insulating film 203 exposed through the openings in the sub lines 123 are removed. Thus, the electrode terminals 121 are exposed through the openings in the first insulating film 203 and the sub lines 123. In addition, given portions of the drawing lines 122 are exposed through the openings passing through the interlayer insulating film 209, the sub lines 123, and the first insulating film 203.

For the patterning of the interlayer insulating film 209 and the first insulating film 203, dry etching using Cl₂ gas or BCl₃ gas is preferably used.

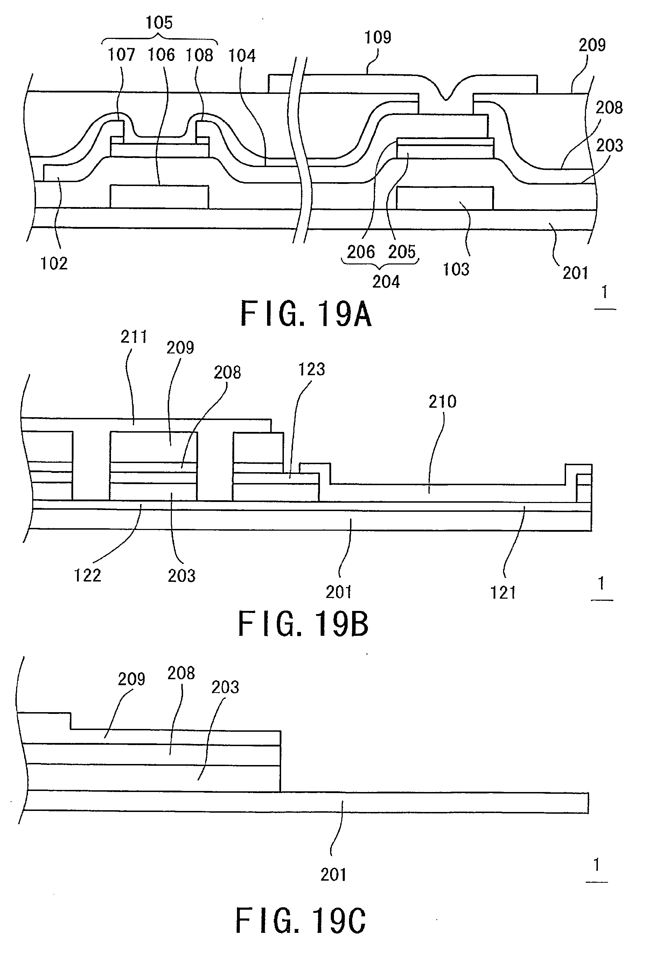

Then, the pixel electrodes 109 are formed in the display region 11 as shown in Fig. 19A. In this step, the conductive material films 210 superimposed on the electrode terminals 121 and the conductive material films 211 superimposed on the drawing lines 122 are formed as shown in Fig. 19B.

To be specific, a material of the pixel electrodes 109 and the conductive material films 210 and 211 (the material of the pixel electrodes 109 and the conductive material films 210 and 211 define the third conductor film 212) is formed preferably by sputtering on the transparent substrate 201 having passed through the above described steps. For the third conductor film 212, ITO (Indium Tin Oxide) about 100 nm in thickness is preferably used. A photoresist material film is then formed on the formed third conductor film 212. The formed photoresist material film is irradiated with light energy through a photomask having given light shielding patterns and given light transmitting patterns.

If the photoresist material film is positive, in the display region 11, the portions to be the pixel electrodes 109 are shielded against light energy, and the other portions are irradiated with light energy. In the panel frame region 12, the portions between the electrode terminals 121, the portions between the drawing lines 122, and the portions in the peripheral portion of the interlayer insulating film 209 are irradiated with light energy, and the portions superimposed on the electrode terminals 121 and the drawing lines 122 are shielded against light energy.

The photoresist material film irradiated with light energy is subjected to development. After the photoresist material film is subjected to the development, the portions irradiated with light energy are removed. In the display region 11, the portions corresponding to the pixel electrodes 109 remain, and the portions between the pixel electrodes 109 are removed. In the panel frame region 12, the portions between the electrode terminals 121, the portions between the drawing lines 122, and the portions covering the peripheral portion of the interlayer insulating film 209 are removed.

Next, the third conductor film 212 is subjected to patterning by using the photoresist material film having been subjected to the development as a mask. For the patterning of the third conductor film 212, wet etching using ferric chloride is preferably used. By this patterning, the portions of the third conductor film 212 covered with the photoresist material film remain, and the other portions are removed. Thus, in the display region 11, the pixel electrodes 109 remain, and the portions between the pixel electrodes 109 are removed. In the panel frame region 12, the portions of the third conductor film 212 on the electrode terminals 121 and superimposed on the drawing lines 122 remain, and the other portions are removed. Accordingly, the conductive material films 210 made from the third conductor film 212 are formed on the electrode terminals 121. In addition, the conductive material films 211 are formed at the portions superimposed on the drawing lines 122 while interposing the interlayer insulating film 209. The conductive material films 210 formed on the electrode terminals 121 are physically separate from the conductive material films 211 superimposed on the drawing lines 122.

Having passed through the above described steps, the display panel substrate 1 according to the preferred embodiment of the present invention is produced.

Next, a method for producing a display panel according to the preferred embodiment of the present invention will be provided. The method of producing the display panel includes a step of producing a TFT array substrate, a step of producing a color filter, and a step of producing a panel (cell). The step of producing a TFT array substrate is as described above.

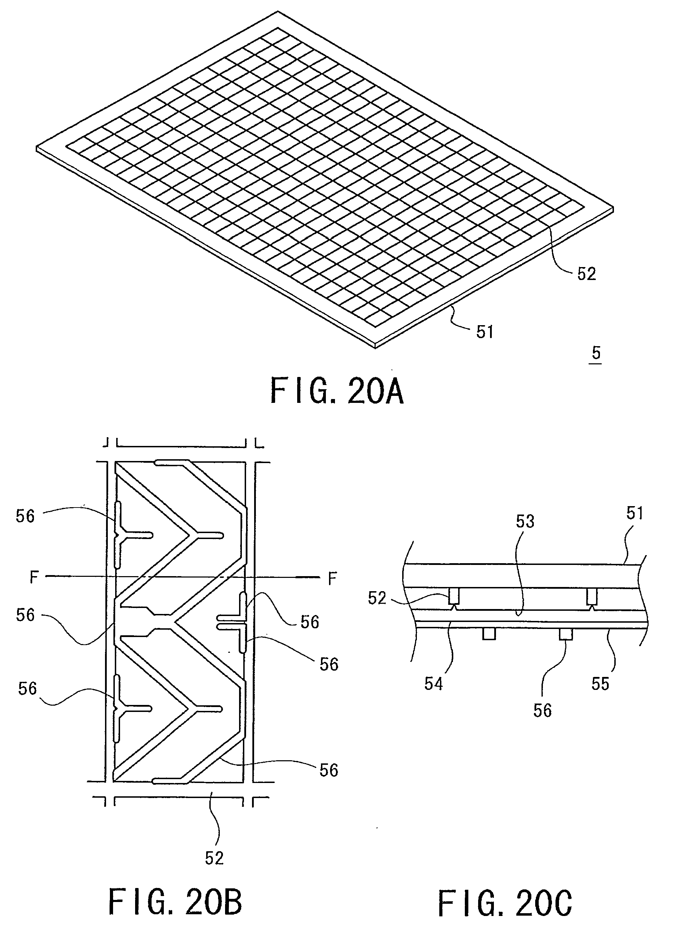

The configuration of the color filter 5 and the method for producing the same are as follows. Figs. 20A to 20C are views schematically showing the configuration of the color filter 5. Fig. 20A is a perspective view schematically showing the overall structure of the color filter 5. Fig. 20B is a plan view of the configuration of one pixel in the color filter 5. Fig. 20C is a cross-sectional view showing the cross-sectional structure of the pixel along the line F-F in Fig. 20B.

As shown in Figs. 20A to 20C, the color filter 5 is configured such that a black matrix 52 is formed on a transparent substrate 51 preferably made of glass. Color layers 53 of red, green, and blue color resists are provided in squares of the black matrix 52. The squares in which the color layers 53 are provided are arranged in a given order. A protective film 54 is formed on the black matrix 52 and the color layers 53. A common electrode 55 is formed on the protective film 54. Alignment control structural elements 56 arranged to control alignment of liquid crystals are formed on the common electrode 55.

The step of producing a color filter includes a step of forming a black matrix, a step of forming color layers, a step of forming a protective film, and a step of forming a common electrode.

The step of forming a black matrix by resin BM for example is performed as follows. First, a BM photoresist (a photosensitive resin material containing a black coloring material) is applied on the transparent substrate 51. Then, the applied BM photoresist is formed into a given pattern preferably by photolithography, and the black matrix 52 of a given pattern is obtained.

In the step of forming color layers, the color layers 53 of red, green, and blue colors for color display are formed. In the case of using a color sensitive material method, a color sensitive material (a solution in which a pigment of a given color is dispersed in a photosensitive material) is applied on the transparent substrate 51 on which the black matrix 52 has been formed. Then, the applied color sensitive material is formed into a given pattern preferably by photolithography. This step is repeated for each of red, green, and blue colors. Thus, the color layers 53 of red, green, and blue colors are obtained. A method for drop filling the materials of the color layers 53 (e.g., resin compositions containing coloring agents of give colors) in the squares of the black matrix 52 with the use of an inkjet printer may be used.

The method used in the step of forming a black matrix is not limited to the resin BM method, and various known methods such as a chromium BM method and an overlap method may be used. The method used in the step of forming color layers is not limited to the color resist method, and various known methods such as a printing method, a dyeing method, an electrodeposition method, a transfer method, and a photo-etching method may be used. It is also preferable to use a back-face exposure method of forming the color layers 53 first and forming the black matrix 52 subsequently.

In the step of forming a protective film, the protective film 54 is formed on the black matrix 52 and the color layers 53 preferably using a method in which a protective film material is applied on the transparent substrate 51 having passed through the above described steps with the use of a spin coater (an overcoating method), and a method of forming the protective film 54 of a given pattern preferably by printing and photolithography (a patterning method). The protective film material is preferably an acrylic resin or an epoxy resin.

In the step of forming a common electrode, the common electrode 55 is formed on the protective film 54. In the case of forming the common electrode 55 by masking, a mask is placed on the transparent substrate 51 having passed through the above described steps and ITO is preferably evaporated onto the mask preferably by sputtering, and the common electrode 55 is formed.

Then, the alignment control structural elements 56 are formed. The alignment control structural elements 56 are preferably made from a photosensitive material preferably by photolithography. A photosensitive material is applied on the transparent substrate 51 having passed through the above described steps and is exposed through a photomask so as to have a given pattern. Then, unnecessary portions are removed therefrom in a subsequent step of development, and the alignment control structural elements 56 of a given pattern are accordingly formed.

By performing the above described steps, the color filter 5 is produced.

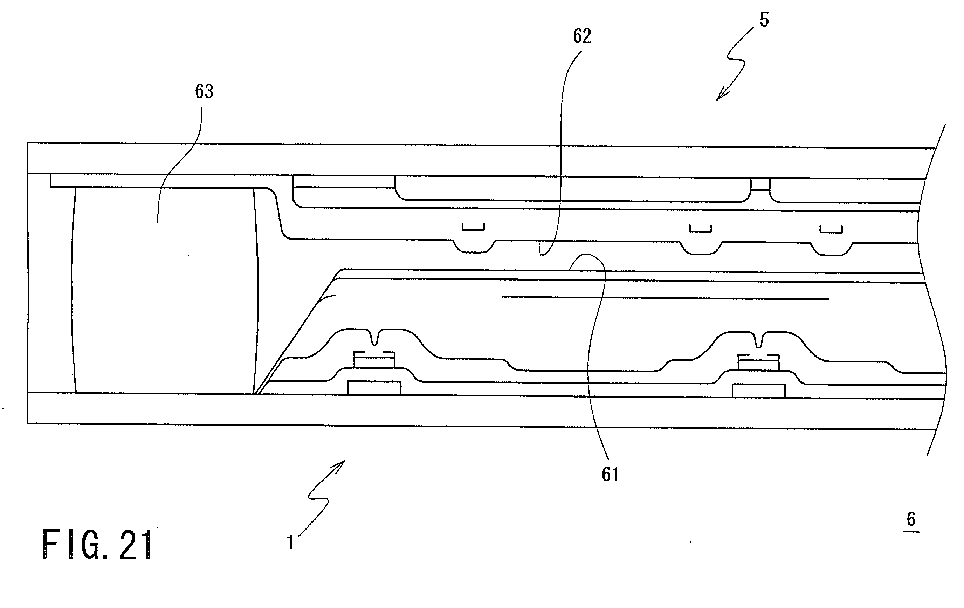

Next, the step of producing a panel is described. Fig. 21 is a cross-sectional view schematically showing the cross-sectional structure of a portion of a display panel 6 according to the preferred embodiment of the present invention. First, an alignment layer 61 is formed on the TFT array substrate having passed through the above described steps (i.e., the display panel substrate 1 according to the preferred embodiment of the present invention), and an alignment layer 62 is formed on the color filter 5. The formed alignment layers 61 and 62 are subjected to alignment processing (the alignment layers 61 and 62 may not be subjected to alignment processing). Then, the display panel substrate 1 and the color filter 5 are bonded together and a space therebetween is filled with liquid crystals.

The alignment layers 61 and 62 are formed on the display panel substrate 1 and the color filter 5 in the following manner. First, an alignment material is applied on the display panel substrate 1 and the color filter 5 preferably using an alignment material coating device. An alignment material refers to a solution which contains a substance from which an alignment layer is made. As the alignment material coating device, an ink-jet press machine (dispenser) is preferably used.

Then, the applied alignment material is heated and baked preferably using a baking system.

Next, the baked alignment layers 61 and 62 are subjected to alignment processing. For the alignment processing, various known processing methods such as a method in which tiny scratches are made on an alignment layer using a rubbing roll and optical alignment processing in which surface properties of an alignment layer are adjusted by irradiating the alignment layer with light energy such as ultraviolet light are used. The baked alignment layers 61 and 62 may not be subjected to alignment processing as already described.

Next, a sealing material 63 is applied on the display panel substrate 1 preferably by using a seal patterning device so as to surround the display region 11 of the display panel substrate 1.

Spacers for keeping a cell gap uniform at a given thickness are sprayed on the display panel substrate 1 preferably using a spacer sprayer. Columnar spacers may be formed on the display panel substrate 1 or the color filter 5. In this case, it is not necessary to spray the spacers. Liquid crystals are drop filled in a region surrounded by the sealing material 63 on the display panel substrate 1 preferably using a liquid crystal drop fill device.

Then, the display panel substrate 1 and the color filter 5 are bonded together in a reduced pressure atmosphere. The sealing material 63 is irradiated with and cured by ultraviolet rays. Liquid crystals may be injected between the display panel substrate 1 and the color filter 5 after the sealing material 63 is cured.

By performing the above described steps, the display panel 6 according to the preferred embodiment of the present invention is obtained.

While preferred embodiments of the present invention have been described above, it is to be understood that variations and modifications will be apparent to those skilled in the art without departing from the scope and spirit of the present invention.

## Claims

1. A display panel substrate comprising:
an electrode terminal for connecting an external circuit board;
a drawing line electrically continuous to the electrode terminal;
an interlayer insulating film covering the drawing line;
a conductive material film superimposed on the electrode terminal and electrically continuous to the electrode terminal; and
a conductive material film superimposed on the drawing line while interposing the interlayer insulating film and electrically continuous to the drawing line,
wherein the conductive material film superimposed on the electrode terminal and the conductive material film superimposed on the drawing line while interposing the interlayer insulating film are separate in a peripheral portion of the interlayer insulating film.

2. The display panel substrate according to claim 1, the conductive material film superimposed on the drawing line while interposing the interlayer insulating film and electrically continuous to the drawing line is electrically continuous to the drawing line through an opening provided to the interlayer insulating film.

3. The display panel substrate according to claim 1 or 2, wherein a portion of the conductive material film superimposed on the drawing line while interposing the interlayer insulating film that is close to the peripheral portion of the interlayer insulating film has a width smaller than a width of the other portion.

4. A display panel substrate comprising:
a plurality of electrode terminals for connecting an external circuit board;
a plurality of drawing lines each electrically continuous to the plurality of electrode terminals;
an interlayer insulating film covering the plurality of drawing lines;
conductive material films each superimposed on the plurality of electrode terminals and each electrically continuous to the plurality of electrode terminals; and
conductive material films each superimposed on the plurality of drawing lines while interposing the interlayer insulating film and each electrically continuous to the plurality of drawing lines,
wherein the plurality of drawing lines are parallel to one another, and
the conductive material films each superimposed on the plurality of electrode terminals and the conductive material films each superimposed on the plurality of drawing lines while interposing the interlayer insulating film are separate in a peripheral portion of the interlayer insulating film, and the conductive material films each superimposed on the adjacent plurality of drawing lines while interposing the interlayer insulating film are separate.

5. The display panel substrate according to claim 4, wherein the conductive material films superimposed on the drawing lines while interposing the interlayer insulating film and electrically continuous to the drawing lines are electrically continuous to the drawing lines through openings provided to the interlayer insulating film.

6. The display panel substrate according to claim 4 or 5, wherein portions of the conductive material films superimposed on the drawing lines while interposing the interlayer insulating film that are close to the peripheral portion of the interlayer insulating film have a width smaller than a width of the other portions.

7. The display panel substrate according to claim 4 or 5, wherein portions of the conductive material films superimposed on the drawing lines while interposing the interlayer insulating film that are close to the peripheral portion of the interlayer insulating film have a width smaller than a width of the other portions, and
an interval between the portions having the smaller width of the conductive material films superimposed on the adjacent drawing lines while interposing the interlayer insulating film is greater than an interval between the other portions of the conductive material films superimposed on the adjacent drawing lines while interposing the interlayer insulating film.

8. The display panel substrate according to any one of claims 4 to 7, wherein a thickness of portions in the peripheral portion of the interlayer insulating film between the plurality of drawing lines is smaller than a thickness of portions of the interlayer insulating film each superimposed on the plurality of drawing lines.

9. A display panel comprising:
the display panel according to any one of claims 1 to 8; and
a common substrate,
wherein the display panel substrate and the common substrate are opposed to each other leaving a given gap therebetween, and liquid crystals are filled between the display panel substrate and the common substrate.
